# EUROPÄISCHE PATENTSCHRIFT

(11) **EP 3 300 528 B1**
(45) Veröffentlichungstag und Bekanntmachung des Hinweises auf die Patenterteilung: **06.03.2019**
(21) Anmeldenummer: 16726057.9
(22) Anmeldetag: 23.05.2016
(51) Int. Cl.: H01H 1/54, H01H 33/666, G01R 31/327, H01H 3/32

(54) **SCHALTGERÄT MIT EINER VAKUUMRÖHRE**
SWITCHING DEVICE COMPRISING A VACUUM TUBE
APPAREIL DE COMMUTATION COMPORTANT UN TUBE À VIDE

(30) Priorität: 11.09.2015 DE 102015217403
(43) Veröffentlichungstag der Anmeldung: 04.04.2018
(73) Patentinhaber: Siemens Aktiengesellschaft, 80333 München (DE)
(72) Erfinder: BINDRICH, Martin, 13467 Berlin (DE)
(86) Internationale Anmeldenummer: PCT/EP2016/061548
(87) Internationale Veröffentlichungsnummer: WO 2017/041913

(56) Entgegenhaltungen:
- EP-A- 0 355 817
- DE-T5-112011 105 570
- US-A- 5 679 986
- US-A1- 2003 123 212
- US-A1- 2009 052 107

## Beschreibung

Die Erfindung betrifft ein Schaltgerät mit einer Vakuumröhre und einem einstellbaren Antrieb zum Öffnen und Schließen der Kontakte des Schaltgeräts.

Schaltgeräte zum Schalten von elektrischen Strömen können Vakuumröhren enthalten. In der DE 32 16 251 A1 wird beispielsweise eine Vakuumröhre zum Schalten eines elektrischen Stromes offenbart. Diese Vakuumröhre enthält einen Bewegkontakt und einen Festkontakt, die zum Ausschalten des elektrischen Stromes voneinander getrennt werden können, und die zum Einschalten des elektrischen Stromes in Kontakt gebracht werden.

Die Schalteigenschaften eines solchen Schaltgeräts mit einer Vakuumröhre, wie sie z. B. in Leistungsschaltern oder Schützen verwendet werden, werden üblicherweise an die Eigenschaften des Betriebsortes angepasst. So hängt beispielsweise bei einem Schaltgerät mit Vakuumröhren die Schaltkraft vom Luftdruck und damit von der Höhenlage ab. Ein weiterer Aspekt ist die Aufstellungsrichtung, bei der die Gravitation in Richtung oder entgegengesetzt der Schaltrichtung wirken kann. Dadurch wird die Schaltung beschleunigt oder gebremst. Unterschiedliche Schaltkräfte führen zu vom Sollwert abweichenden Schaltgeschwindigkeiten und Zeiten. Diese Unterschiede müssen idealerweise vollständig korrigiert werden.

In der US 2009/052107 A1 wird eine Steuerung für einen Vakuumschütz offenbart, wobei diese Steuerung den barometrischen Druck misst und einen kurzen Impedanzcharakterisierungsimpuls an die Spulen der Vakuumschützspulen liefert, um geeignete Betriebsbedingungen der Spulen zu beurteilen und um Spulen- oder Sensorfehler zu prüfen.

Die DE 11 2011 105570 T5 beschreibt eine elektromagnetische Betätigungsvorrichtung für einen Vakuum-Leistungsschalter, die durch ihre elektromagnetische Betätigung die Geschwindigkeit des Kontaktschaltvorgangs einer bei dem Vakuum-Leistungsschalter verwendeten Vakuum-Schaltröhre steuert, wobei die elektromagnetische Betätigungsvorrichtung Folgendes aufweist: eine Schliessantriebsspule für die Vakuum-Schaltröhre; und einen ersten Temperatursensor, der eine Temperatur in der Umgebung der Schliessantriebsspule misst, wobei ein Strom, der durch die Schliessantriebsspule hindurchgeleitet wird, auf der Basis der von dem ersten Temperatursensor gemessenen Temperatur gesteuert wird.

Der Erfindung liegt daher die Aufgabe zugrunde, ein Schaltgerät mit einer Vakuumröhre anzugeben, welches sich automatisch in den Eigenschaften des Öffnens und Schließens des Schaltgeräts dem Betriebsort anpassen kann.

Diese Aufgabe wird erfindungsgemäß durch ein Schaltgerät mit einer Vakuumröhre und einem einstellbaren Antrieb gemäß Anspruch 1 gelöst. Vorteilhafte Ausgestaltungen des erfindungsgemäßen Schaltgeräts sind in Unteransprüchen angegeben.
Das erfindungsgemäße Schaltgerät mit einer Vakuumröhre und einem einstellbaren Antrieb zum Öffnen und Schließen der Kontakte des Schaltgeräts gemäß Anspruch 1 umfasst einen Sensor zur Erfassung von physikalischen Eigenschaften des Betriebsortes des Schaltgeräts, wobei der Sensor ein Sensor zur Messung der Lage des Schaltgeräts ist, sowie einen Mikrocontroller, der das Signal des Sensors auswertet, und den einstellbaren Antrieb zum Öffnen und Schließen der Kontakte dynamisch dem Betriebsort anpasst.
Vorteilhaft ist, dass ein solches Schaltgerät an Betriebsorten eingesetzt werden kann mit stark schwankenden physikalischen Eigenschaften.

Vorteilhaft hierbei ist, dass ein solches Schaltgerät beispielsweise an einem Betriebsort mit stark schwankenden Druckverhältnissen eingesetzt werden kann. Dies kann beispielsweise ein Fahrstuhl eines Minenschachts sein, bei dem aufgrund der Änderung der Höhe die Druckverhältnisse stark schwanken. Ebenso ist es vorteilhaft, dass bei Schaltgeräten, die im Betrieb geschwenkt werden, wie dies beispielsweise auf Kränen der Fall sein kann, das Schaltgerät ebenfalls der Betriebslage angepasst werden kann.
In einer weiteren Ausgestaltung wird durch den einstellbaren Antrieb zum Öffnen und Schließen die Kraft auf die Kontakte dem Betriebsort angepasst.
In einer weiteren Ausgestaltung umfasst der einstellbare Antrieb zum Öffnen und Schließen eine Spule, die dem elektromagnetischen Einstellen der Schalterkraft durch den einstellbaren Antrieb zum Öffnen und Schließen dient. Die Kraft des einstellbaren Antriebs zum Öffnen und Schließen kann dabei durch Steuerung des Spulenstroms angepasst werden.

In einer alternativen Ausgestaltung umfasst der einstellbare Antrieb zum Öffnen und Schließen mindestens eine Feder, deren veränderbare Federkraft zum Einstellen der Kraft auf die Kontakte durch den einstellbaren Antrieb zum Öffnen und Schließen dient. Hierbei kann die Kraft des Antriebs zum Öffnen und Schließen der Kontakte durch die Veränderung der Länge des Federwegs angepasst werden.

In einer weiteren Ausgestaltung wird die Kraft des Antriebs zum Öffnen und Schließen der Kontakte dynamisch während des Betriebs des Schaltgeräts angepasst. Es kann dynamisch während des Betriebs des Schaltgeräts die Kontaktkraft dem Betriebsort angepasst werden.

Die oben beschriebenen Eigenschaften, Merkmale und Vorteile dieser Erfindung, sowie die Art und Weise, wie sie erreicht werden, werden klarer und deutlicher verständlich im Zusammenhang mit der folgenden Beschreibung der Ausführungsbeispiele, die in Zusammenhang mit den Figuren näher erläutert werden.

Dabei zeigen:
- Figur 1: Schaltgerät mit Vakuumröhre mit geschlossenen Kontakten;
- Figur 2: Schaltgerät mit Vakuumröhre mit geöffneten Kontakten;
- Figur 3: Schaltgerät mit Vakuumröhre und Sensoren; und
- Fig. 4A/4B: Schaltgerät mit Vakuumröhre und einstellbarem Antrieb.

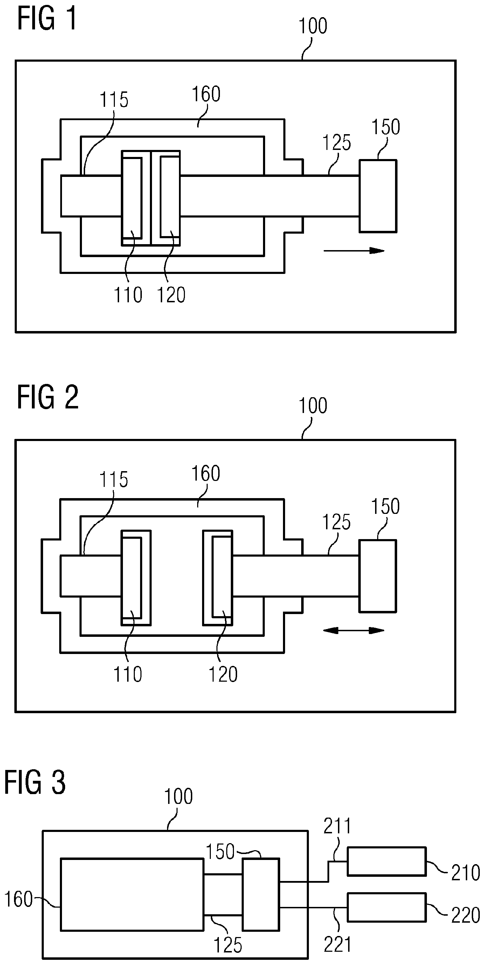

In Figur 1 ist ein Schaltgerät 100 mit einer Vakuumröhre 160 und einem einstellbaren Antrieb 150 zum Öffnen und Schließen der Kontakte 110; 120 des Schaltgeräts 100 dargestellt. Die Vakuumröhre 160 umfasst einen Festkontakt 110, der auf einem Bolzen 115 montiert ist und einen Bewegkontakt 120, der über einen Bolzen 125 bewegt werden kann. Entsprechend der Darstellung in Figur 1 sind die Kontakte 110; 120 in der Schließstellung, so dass ein Strom fließen kann.

Das Schaltgerät 100 umfasst einen Antrieb 150 zum Öffnen und Schließen der Kontakte 110; 120. Dieser Antrieb 150 kann entsprechend der Darstellung in der Figur 1 zum Öffnen der Kontakte 110; 120 den Bewegkontakt 120 in Pfeilrichtung nach rechts bewegen.

Dies ist näher in der Figur 2 dargestellt, in der der Festkontakt 110 vom Bewegkontakt 120 getrennt ist. Der einstellbare Antrieb 150 hat die Kontakte 110; 120 getrennt.

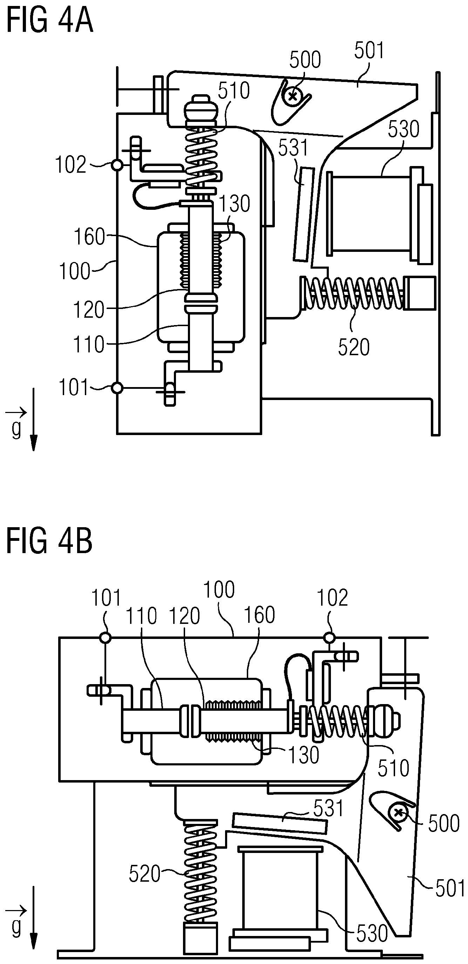

In den Figuren 4A und 4B ist das Schaltgerät 100 näher dargestellt. Neben den Kontakten 110; 120 umfasst die Vakuumröhre 160 einen Faltenbalg 130, der für eine Abdichtung des beweglichen Kontakts 120 sorgt. Das Schaltgerät 100 ist typischerweise so eingestellt, dass die Kraft des Faltenbalgs 130 auf den Bolzen 125 entgegengesetzt gleich der äußeren Kraft aufgrund des Druckunterschieds zwischen dem Vakuum in der Vakuumröhre 160 und dem Betriebsort ist.

In den Figuren 4A und 4B sind zusätzlich die äußeren elektrischen Kontakte 101; 102 dargestellt, an denen der Strompfad des zu schaltenden Verbrauchers angeschlossen wird.

Der einstellbare Antrieb 150 zum Öffnen und Schließen der Kontakte 110; 120 umfasst einen Anker 501, der um eine Achse 500 drehbar gelagert ist. Entsprechend der Darstellung der Figuren 4A und 4B sind die Kontakte 110; 120 geöffnet, somit voneinander entfernt. Durch eine Bewegung des Ankers gegen den Uhrzeigersinn entsprechend der Darstellung in Figur 4A wird der Bewegkontakt 120 auf den Festkontakt 110 zu bewegt und so der elektrische Strompfad des Schaltgeräts 100 geschlossen.

Der einstellbare Antrieb 150 umfasst des Weiteren eine Feder 510, die dafür sorgt, dass die Kontakte 110; 120 im geschlossenem Zustand mit einer definierten Kraft gegeneinander gedrückt werden. Zusätzlich umfasst der Antrieb 150 einen Elektromagneten mit einer Spule 530, der auf ein Gegenstück 531 am Anker 501 wirkt und durch Beaufschlagung eines Spulenstroms den Anker gegen den Uhrzeigersinn dreht. Durch diese Drehung wird der elektrische Kontakt des Schaltgeräts 100 geschlossen. Außerdem umfasst der Antrieb eine Öffnungsfeder 520, welche bei Abschalten des Elektromagneten mit Spule 530 die Kontakte öffnet.
Entsprechend der Lage des Schaltgeräts 100 wirken unterschiedliche Kräfte auf den Anker und müssen unterschiedliche Kräfte vom Anker aufgebracht werden, um das Schaltgerät 100 zu schließen. Dies ist beispielsweise in Figur 4B dargestellt, die den elektrischen Schalter 100 aus Figur 4A um 90° gedreht darstellt. In so einer Konfiguration wirken andere Kräfte auf dem Anker aufgrund der Schwerkraft g, so dass hier ein anderer Abgleich des Antriebs 150 notwendig ist. Ebenso wirkt sich eine Änderung des Luftdrucks auf die Kraft aus, mit der der Bewegkontakt 120 gegen den Festkontakt 110 gedrückt werden muss beispielsweise zum Halten des Kontakts während des Stromflusses.

In Figur 3 ist dargestellt, dass das Schaltgerät 100 zusätzlich Sensoren 210; 220 umfasst, zur Erfassung von physikalischen Eigenschaften des Betriebsortes des Schaltgeräts 100. Anhand der erfassten Eigenschaften wird der einstellbare Antrieb 150 zum Öffnen und Schließen der Kontakte 110; 120 den Betriebsort angepasst.

Der Sensor 210 kann beispielsweise ein Sensor zur Messung des Luftdrucks sein; der Sensor 220 ist ein Sensor zur Messung der Lage des Schaltgeräts 100. Der Sensor 210 ist über eine Leitung 211 mit dem Antrieb 150 zum Öffnen und Schließen der Kontakte 110; 120 verbunden. Zum Anpassen des einstellbaren Antriebs 150 an den Betriebsort kann dieser einen Mikrocontroller umfassen, der das Signal des Sensors auswertet und die notwendige Anpassungen vornimmt. Alternativ kann diese Steuerung auch separat vom Antrieb 150 vorgenommen werden.
Ebenso ist der Sensor 220 über die Leitung 221 mit dem einstellbaren Antrieb 150 zum Öffnen und Schließen der Kontakte 110; 120 verbunden. Die Anpassung des einstellbaren Antriebs 150 zum Öffnen und Schließen an den Betriebsort wird über eine Anpassung der Schaltkraft auf die Kontakte 110; 120 vorgenommen. Enthält dazu das Schaltgerät 100 eine Spule 530, wie es in den Figuren 4A und 4B dargestellt ist, so kann die Kraft auf die Kontakte 110; 120 durch eine Änderung des Spulenstroms vorgenommen werden. Dazu werden die elektrischen Signale der Sensoren 210; 220, die den physikalischen Eigenschaften entsprechen, ausgewertet und der Spulenstrom entsprechend angepasst.
Es ist ebenso möglich, die Federkräfte der Feder 510; 520 anzupassen. Dies kann beispielsweise mittels eines elektromechanischen Antriebs geschehen, der die Längen der Federwege der Federn 510; 520 anpasst.
Die Anpassung der Kraft des Antriebs 150 zum Öffnen und Schließen der Kontakte 110; 120 sowie die Kraft der Andruckfeder 510 und der Öffnungsfeder 520 kann dynamisch sein. Dies bedeutet, dass die Kraft während des Betriebs dynamisch angepasst wird. Beispielsweise kann dadurch sichergestellt werden, dass bei Änderungen beispielsweise des Drucks, wie dies in einem Mienenfahrstuhl der Fall ist, immer die Kraft auf die Kontakte 110; 120 dynamisch angepasst und so konstant gehalten wird.

Durch die Erfassung der Umgebungsbedingungen z. B. durch einen Sensor zur Messung des Luftdrucks oder einen Sensor zur Messung der Lage des Schaltgeräts 100 kann die Steuerelektronik die Schalteigenschaften der aktuellen Umgebungssituation anpassen. Durch eine Erhöhung des Spulenstroms oder eine Änderung der Federkonstante der Federn 510; 520 gegenüber dem Normalwert können Änderungen der Umgebungsbedingungen auf den Schalter 100 zurückwirken, so dass dieser immer einen konstanten Auslösewert hat. Damit können Umgebungsbedingungen, die negativ auf den Schaltvorgang wirken, vollständig kompensiert werden. Ebenso können positiv wirkende Umgebungsbedingungen, beispielsweise durch eine Absenkung des Spulenstroms, kompensiert werden.

Durch eine dynamische Anpassung können neue Applikationen ermöglicht werden, für die eine feste Anpassung eines Schaltgeräts 100 ungeeignet ist. Beispielsweise bei Applikationen, bei denen das Schaltgerät 100 stark schwankenden Druckverhältnissen ausgesetzt ist oder wechselnde Bezugslagen aufweist.

## Patentansprüche

1. Schaltgerät (100) mit einer Vakuumröhre (160) und einem einstellbaren Antrieb (150) zum Öffnen und Schließen der Kontakte (110; 120) des Schaltgeräts (100), wobei das Schaltgerät (100) einen Sensor (210; 220) umfasst zur Erfassung von physikalischen Eigenschaften des Betriebsorts des Schaltgeräts (100),
wobei das Schaltgerät (100) einen Mikrocontroller umfasst, der das Signal des Sensors (210; 220) auswertet, und den einstellbaren Antrieb (150) zum Öffnen und Schließen der Kontakte (110; 120) dynamisch dem Betriebsort anpasst,
**dadurch gekennzeichnet, dass**
der Sensor (210; 220) ein Sensor zur Messung der Lage des Schaltgeräts (100) ist.

2. Schaltgerät (100) mit einer Vakuumröhre (160) gemäß Anspruch 1, bei dem die Kraft auf die Kontakte (110; 120) durch den einstellbaren Antrieb (150) zum Öffnen und Schließen dem Betriebsort angepasst wird.

3. Schaltgerät (100) mit einer Vakuumröhre (160) gemäß einem der vorherigen Ansprüche, bei dem der einstellbare Antrieb (150) zum Öffnen und Schließen eine Spule (530) umfasst, die dem elektromagnetischen Einstellen der Schalterkraft durch den einstellbaren Antrieb (150) zum Öffnen und Schließen dient.

4. Schaltgerät (100) mit einer Vakuumröhre (160) gemäß Anspruch 3, bei dem die Kraft des einstellbaren Antriebs (150) zum Öffnen und Schließen durch eine Steuerung des Spulenstroms vorgenommen wird.

5. Schaltgerät (100) mit einer Vakuumröhre (160) gemäß einem der Ansprüche 1 bis 2, bei dem der einstellbare Antrieb (150) zum Öffnen und Schließen mindestens eine Feder (510) umfasst, deren veränderbare Federkraft zum Einstellen der Kraft auf die Kontakte (110; 120) durch den einstellbaren Antrieb (150) zum Öffnen und Schließen dient.

6. Schaltgerät (100) mit einer Vakuumröhre (160) gemäß Anspruch 5, bei dem die Kraft des Antriebs (150) zum Öffnen und Schließen der Kontakte (110; 120) durch die Veränderung der Länge des Federwegs der Federn (510; 520) vorgenommen wird.

7. Schaltgerät (100) mit einer Vakuumröhre (160) gemäß einem der vorherigen Ansprüche, bei dem dynamisch während des Betriebs des Schaltgeräts (100) die Kraft des Antriebs (150) zum Öffnen und Schließen der Kontakte (110; 120) angepasst wird.

8. Schaltgerät (100) mit einer Vakuumröhre (160) gemäß Anspruch 7, bei dem dynamisch während des Betriebs des Schaltgeräts (100) die Kontaktkraft dem Betriebsort angepasst wird.

## Claims

1. Switching device (100) comprising a vacuum tube (160) and an adjustable drive (150) for opening and closing the contacts (110; 120) of the switching device (100), wherein
the switching device (100) comprises a sensor (210; 220) for detecting physical properties of the operating location of the switching device (100), wherein the switching device (100) comprises a microcontroller which evaluates the signal of the sensor (210; 220) and adapts the adjustable drive (150) for opening and closing the contacts (110; 120) dynamically to the operating location,
**characterized in that**
the sensor (210; 220) is a sensor for measuring the position of the switching device (100).

2. Switching device (100) comprising a vacuum tube (160) according to Claim 1, wherein the force acting on the contacts (110; 120) is adapted to the operating location by the adjustable drive (150) for opening and closing.

3. Switching device (100) comprising a vacuum tube (160) according to one of the preceding claims, in which the adjustable drive (150) for opening and closing comprises a coil (530) which serves to form the electromagnetic adjustment of the switch force by the adjustable drive (150) for opening and closing.

4. Switching device (100) comprising a vacuum tube (160) according to Claim 3, in which the force of the adjustable drive (150) for opening and closing is provided by controlling the coil current.

5. Switching device (100) comprising a vacuum tube (160) according to one of Claims 1 to 2, in which the adjustable drive (150) for opening and closing at least one spring (510) whose adjustable spring force serves to adjust the force acting on the contacts (110; 120) by means of the adjustable drive (150) for opening and closing.

6. Switching device (100) comprising a vacuum tube (160) according to Claim 5, in which the force of the drive (150) for opening and closing the contacts (110; 120) is provided by changing the length of the spring travel of the springs (510; 520).

7. Switching device (100) comprising a vacuum tube (160) according to one of the preceding claims, in which the force of the drive (150) for opening and closing the contacts (110; 120) is adapted dynamically while the switching device (100) is operating.

8. Switching device (100) comprising a vacuum tube (160) according to Claim 7, in which the contact force is dynamically adapted to the operating location while the switching device (100) is operating.

## Revendications

1. Appareil de commutation (100) doté d'un tube à vide (160) et d'un dispositif d'actionnement réglable (150) pour ouvrir et fermer les contacts (110, 120) de l'appareil de commutation (100), dans lequel
l'appareil de commutation comprend un capteur (210, 220) permettant de détecter des propriétés physiques de l'emplacement de service de l'appareil de commutation (100), et
l'appareil de commutation (100) comprend un microcontrôleur qui évalue le signal du capteur (210, 220) et adapte le dispositif d'actionnement réglable (150) pour ouvrir et fermer les contacts (110, 120) de façon dynamique à l'emplacement de service,
**caractérisé en ce que** le capteur (210, 220) est un capteur de mesure de la position de l'appareil de commutation (100) .

2. Appareil de commutation (100) doté d'un tube à vide (160) selon la revendication 1, dans lequel la force sur les contacts (110, 120) appliquée par le dispositif d'actionnement réglable (150) pour les ouvrir et les fermer est adaptée en fonction de l'emplacement de service.

3. Appareil de commutation (100) doté d'un tube à vide (160) selon l'une des revendications précédentes, dans lequel le dispositif d'actionnement réglable (150) d'ouverture et de fermeture comprend une bobine (530), qui sert au réglage électromagnétique de la force de commutation appliquée par le dispositif d'actionnement réglable (150) d'ouverture et de fermeture.

4. Appareil de commutation (100) doté d'un tube à vide (160) selon la revendication 3, dans lequel la force du dispositif d'actionnement réglable (150) d'ouverture et de fermeture est appliquée par une commande du courant de bobine.

5. Appareil de commutation (100) doté d'un tube à vide (160) selon l'une des revendications 1 à 2, dans lequel le dispositif d'actionnement réglable (150) d'ouverture et de fermeture comprend au moins un ressort (510) dont la force de ressort variable sert à régler la force sur les contacts (110, 120) par le dispositif d'actionnement réglable (150) d'ouverture et de fermeture.

6. Appareil de commutation (100) doté d'un tube à vide (160) selon la revendication 5, dans lequel la force du dispositif d'actionnement (150) pour ouvrir et fermer les contacts (110, 120) est appliquée par une modification de la longueur de la course élastique des ressorts (510, 520) .

7. Appareil de commutation (100) doté d'un tube à vide (160) selon l'une des revendications précédentes, dans lequel la force du dispositif d'actionnement (150) appliquée pour ouvrir et fermer les contacts (110, 120) est adaptée de façon dynamique pendant le fonctionnement de l'appareil de commutation (100).

8. Appareil de commutation (100) doté d'un tube à vide (160) selon la revendication 7, dans lequel la force de contact est adaptée de façon dynamique à l'emplacement de service pendant le fonctionnement de l'appareil de commutation (100) .
